# EUROPEAN PATENT APPLICATION

(11) **EP 4 741 836 A1**
(43) Date of publication of application: **13.05.2026**
(21) Application number: 25206887.9
(22) Date of filing: 06.10.2025
(51) Int. Cl.: G01R 13/02

(54) **TEST AND/OR MEASUREMENT SYSTEM, COMPUTER-IMPLEMENTED METHOD OF GATHERING DATA OF A SIGNAL AND COMPUTER PROGRAM PRODUCT**

(30) Priority: 07.11.2024 US 202418940352
(71) Applicant: Rohde & Schwarz GmbH & Co. KG, 81671 München (DE)
(72) Inventor: Guenther, Mario, 81671 München (DE)
(74) Representative: Prinz & Partner mbB

(57) **Abstract**

The invention relates to a test and/or measurement system (10) having a processing circuit (18) configured to process a signal and to determine at least a first presentation based on a first parameter and a second presentation based on a second parameter when processing the signal, wherein the second parameter is different to the first parameter. The test and/or measurement system (10) comprises a display (16) connected with the processing circuit (18), which is configured to display either the first presentation or the second presentation at the same time. The test and/or measurement system (10) comprises a storage medium (20) configured to store first data associated with the first presentation and second data associated with the second presentation. Further, a computer-implemented method of gathering data of a signal as well as a computer program product are described.

## Description

### TECHNICAL BACKGROUND

The invention relates to a test and/or measurement system. Further, the invention relates to a computer-implemented method of gathering data of a signal. Moreover, the invention relates to a computer program product.

### BACKGROUND

In modern test and/or measurement devices, e.g. oscilloscopes, spectrum analyzers, network analyzers, signal analyzers, and the like, many information can be gathered which however due to the screen structure of the test and/or measurement devices cannot be displayed simultaneously, namely at the same time. Consequently, it is known in the state of the art to use tabulators so as to provide different windows for the different information, thereby enabling a user to manually switch between the different information by clicking the respective tabulator. The different information may relate to long tables which content cannot be fully displayed, but only partly, as well as to completely different information like different diagrams or graphs of the same signal, wherein the different diagrams may be obtained by using different parameters.

However, when performing a screenshot of the information provided, only the currently displayed information is stored rather than all information available. In other words, the respective information associated with a non-activate tabulator is not available in the screenshot.

In the state of the art, a user has to manually and actively change the settings of the test and/or measurement device, particularly the display, while performing several screenshots when different information is displayed in order to gather all information available, which is neither comfortable nor user-friendly.

Accordingly, there is a need for gathering all information available in a more efficient and user-friendly manner.

### SUMMARY

The invention provides a test and/or measurement system. The test and/or measurement system comprises a processing circuit configured to process a signal. The processing circuit is configured to determine at least a first presentation based on a first parameter and a second presentation based on a second parameter when processing the signal. The second parameter is different to the first parameter. The test and/or measurement system comprises a display connected with the processing circuit. The display is configured to display either the first presentation or the second presentation at the same time. Hence, the display is not configured to display both presentations at the same time, e.g. due to space restrictions of the display. The test and/or measurement system comprises a storage medium configured to store first data associated with the first presentation and second data associated with the second presentation.

The invention provides a computer-implemented method of gathering data of a signal, wherein the method comprises the steps of:
- Processing a signal received;
- Determining, by means of a processing circuit, at least a first presentation based on a first parameter and a second presentation based on a second parameter when processing the signal received, wherein the second parameter is different to the first parameter;
- Outputting a display control signal to display either the first presentation or the second presentation at the same time on a display; and
- Outputting a storage control signal to store first data associated with the first presentation and second data associated with the second presentation in a storage medium.

Therein and in the following, the term "circuit" is understood to describe suitable hardware, or a combination of hardware and software that is configured to have a certain functionality. The hardware may, inter alia, comprise a CPU, a GPU, an FPGA, an ASIC, or other types of electronic circuitry.

The main idea of the invention is to provide an interactive screenshot by the test and/or measurement system such that it is not necessary to manually use different display settings for displaying all information available and to manually make different screenshots of the different information made available while using the different display settings. To the contrary, the test and/or measurement system provides the different data, namely the first data and the second data, which are associated with the different presentations that cannot be display simultaneously by the display. Therefore, information not visible can be stored by the test and/or measurement system, thereby providing the possibility to also analyze the invisible information afterwards when considering the screenshot obtained.

The different parameters, e.g. the first parameter and the second parameter, based on which the corresponding presentations are determined may relate to different illustrations, for instance a table containing values or a graph/diagram (waveform) that graphically illustrates the values. Even though both presentations cannot be displayed at the same time by the display due to the restrictions of the display, the presentations can be stored digitally, namely the first data associated with the first presentation and the second data associated with the second presentation, when performing an interactive screenshot functionality. Consequently, a customer is enabled to interact with the interactive screenshot obtained so as to get the information of all presentations available, particularly information of presentations not currently displayed when performing the interactive screenshot.

Accordingly, the expression "data associated with the presentation" relates to a screenshot, namely the visualization rather than raw (measurement) data based on which the presentation can be determined when performing certain settings on the display. Put differently, the expression "data associated with the presentation" is to be understood in terms of the present disclosure to also encompass settings of the display in addition to raw (measurement) data, e.g. based on which a table, a graph and/or a diagram can be provided. In other words, the expression "data associated with the presentation" relates to the digital representation (data) of a screenshot of the respective presentation.

Generally, the test and/or measurement system may be a single device, e.g. a test and/or measurement device, also called test and/or measurement instrument. Alternatively, the test and/or measurement system comprises several devices that are connected with each other in a signal-transmitting manner, for instance a backend device and a separately formed frontend device. The backend device may be a server structure provided at a different location compared to the frontend device, e.g. the test and/or measurement device. For instance, the backend device may comprise the processing circuit, whereas the frontend device comprises the display. Generally, the display and/or the storage medium may be located at a different place compared to the processing circuit. Particularly, the display is provided at a customer site, whereas the processing circuit and/or the storage medium are server structures, e.g. cloud servers.

An aspect provides that the test and/or measurement system comprises an interactive screenshot functionality which, when activated, causes the processing circuit to store the first data associated with the first presentation and the second data associated with the second presentation. The interactive screenshot functionality ensures that not only a regular screenshot of the currently displayed presentation is stored, namely the corresponding data of the currently displayed presentation, but also the data associated with at least one further presentation that is not currently displayed, thereby distinguishing the interactive screenshot from a regular screenshot.

As indicated above, the data associated with the presentation contains the raw data to be displayed as well as settings of the display, namely configuration data how the raw data is visualized.

Since data of at least two different presentations are stored, it is possible to provide the interactive screenshot, namely a screenshot with the possibility to interact with by having at least one active area in the screenshot, which can be used for interaction.

According to another aspect, the processing circuit is configured to generate an interactive screenshot comprising the first presentation that is displayed on the display. The first presentation is generated based on the first data. The test and/or measurement system comprises an interaction item which, when used, causes the processing circuit to display the second presentation within the interactive screenshot, wherein the second presentation is obtained based on the second data stored. Hence, the first presentation is the one which is currently displayed when the (interactive) screenshot is done, namely by means of the interactive screenshot functionality. By using the interaction item, the customer may change the information visualized in the screenshot, which makes the screenshot interactive. Actually, using the interaction item may make the second presentation visible that was not visible, namely displayed on the display, when the (interactive) screenshot was taken.

Accordingly, the interaction item may be used to select and/or confirm an active area in the interactive screenshot so as to activate the second presentation.

Particularly, the interaction item, when used, switches from the first presentation to the second presentation within the interactive screenshot, wherein the second presentation is obtained based on the second data stored. Thus, the presentation displayed when the (interactive) screenshot was taken, namely the first presentation, will not be displayed anymore once the interaction item was used to display the second presentation, as the first presentation is replaced by the second presentation. This ensures that the information associated with the different presentations can be displayed.

The interaction item may be an active area displayed on the display, e.g. a touch-sensitive area on a touch-sensitive display. Hence, a customer may easily interact with the display in order to change the content visualized by the display by simply touching the active area on the display.

Alternatively or additionally, the interaction item is a button that is separately formed with respect to the display, for instance on a front-end of a test and/or measurement device. The button may relate to a rotational and push button which enables the customer to select a certain active area (e.g. a tabulator) displayed, namely by rotating the button, and to confirm the illustration of the content associated with the active area by pushing the button. Hence, a new table, more entries of an already displayed table, a diagram or a graph (waveform) associated with the certain active area, e.g. the tabulator, is illustrated by the display. In fact, the information associated with the certain active area relates to the second presentation.

The processing circuit may be configured to serially display the first presentation and the second presentation on the display and to obtain successive screenshots of the first presentation and the second presentation while the first presentation and the second presentation are displayed on the display. Accordingly, the different screenshots are obtained in an automatic manner while (re-)setting or (re-)configuring the display automatically and performing successive screenshots so as to obtain screenshots of the different presentations associated with the different settings/configurations. Afterwards, the different screenshots gathered may be merged to the interactive screenshot. This means that the first screenshot associated with the first presentation may be a default screenshot, which has at least one active area that is linked to a second screenshot associated with the second presentation. By activating the active area, e.g. via the interaction item, the second presentation becomes available in the interactive screenshot.

In fact, the respective data associated with the corresponding presentation relates to a screenshot. By having two or more different screenshots, the screenshots can be combined to obtain the interactive screenshot having the at least one active area that provides a link from the first screenshot to the second screenshot. Hence, the at least one active area provides the link between the different presentations/screenshots.

As indicated above, by using the interaction item, the active area in the first screenshot/presentation is used to illustrate the second screenshot/presentation, thereby establishing the interactivity.

A further aspect provides that the processing circuit is configured to store the first data associated with the first presentation and the second data associated with the second presentation without displaying the respective presentations on the display. Hence, the processing circuit is enabled to determine the presentations without actually displaying the presentations. In fact, an output to the display will be intercepted such that the presentations are not displayed (subsequently) which improves the usability, as the currently displayed presentation is not changed for a short moment.

The first data associated with the first presentation and/or the second data associated with the second presentation may comprise additional data not currently displayed when a screenshot of the corresponding presentation is obtained. The additional data may relate to entries of a table, which are not currently displayed, or additional waveform sections not currently displayed. In other words, the additional data provide a so-called scrollshot, namely information that is only obtained when scrolling on the display.

Particularly, the additional data is metadata. The metadata may relate to data in addition to the data directly visualized. The metadata may be amplitude and/or time.

Another aspect provides that the first data associated with the first presentation and/or the second data associated with the second presentation comprise a temporal sequence of at least two time frames. Hence, a short video sequence can be gathered which also differs from a regular screenshot which only corresponds to a certain moment in time.

The first presentation may be associated with a first window and the second presentation may be associated with a second window, wherein the processing circuit may be configured to toggle, upon an input signal, between the first window and the second window for displaying either the first window or the second window. The respective presentations may be illustrated in different windows wherein the display only displays one window. Based on the input signal received, a toggling between the windows can be achieved. As described above, the information provided in the different windows relate to the different presentations which are stored. The input signal may be generated by interacting with the active area, for instance by means of the interaction item.

Particularly, the test and/or measurement system comprises an input interface via which the input signal is provided. The input interface may relate to the interaction item or a signal input such that an automatic toggling can be done, e.g. initiated by a computer. The input signal may be obtained via a code or instruction, e.g. by HTML (Hypertext Markup Language), CSS (Cascading Style Sheets) or JavaScript.

Moreover, the processing circuit may be configured to determine the first presentation and the second presentation automatically in a temporally overlapping manner. The temporally overlapping manner means (substantially) at the same time, which differ from a successive manner according to which the presentations are determined one after another. The automatic determination may be done based on a former measurement history, for instance a lookup-table.

The signal processed by the processing circuit may be a measured signal or a simulated signal. Accordingly, an input signal may be measured by the test and/or measurement system, particularly a test and/or measurement device, so as to obtain the measured signal. However, the signal may also relate to a digital signal that is simulated by the test and/or measurement system for performing virtual tests and/or measurements.

Another aspect provides that the test and/or measurement system is capable of performing a test and/or a measurement on the signal. Hence, information about the signal processed can be gathered by performing the test and/or measurement.

For instance, the test and/or measurement system comprises an oscilloscope, a spectrum analyzer, a network analyzer, a signal analyzer, an audio analyzer, a test device, a protocol tester, a mobile network tester, a measurement device, or a satellite monitoring device. In fact, the test and/or measurement system, e.g. the components described above like the display, the processing circuit and the storage medium, are encompassed in a single test and/or measurement device, which can be an oscilloscope, a spectrum analyzer, a network analyzer, a signal analyzer, an audio analyzer, a test device, a protocol tester, a mobile network tester, a measurement device, or a satellite monitoring device. However, at least one of the components mentioned above, namely the display, the processing circuit and/or the storage medium, may be provided separately with respect to the test and/or measurement device.

The different aspects described above relate to both the test and/or measurement system and the method in a similar manner.

Furthermore, the invention provides a computer program product comprising instructions which, when the computer program product is executed by a processing circuit, cause the processing circuit to carry out the method described above. The respective computer program product may be performed on a server structure, namely a processing circuit of a server structure, which interacts with the display and/or the storage medium.

### DESCRIPTION OF THE DRAWINGS

The foregoing aspects and many of the attendant advantages of the claimed subject matter will become more readily appreciated as the same become better understood by reference to the following detailed description, when taken in conjunction with the accompanying drawings, wherein:
- Figure 1 schematically shows a test and/or measurement system according to an exemplarily embodiment of the invention;
- Figure 2 schematically shows an overview illustrating the concept of generating an interactive screenshot according to an exemplarily embodiment of the invention; and
- Figure 3 schematically shows an overview illustrating an overview of a method of gathering data of a signal according to an exemplarily embodiment of the invention.

### DETAILED DESCRIPTION

The detailed description set forth below in connection with the appended drawings, where like numerals reference like elements, is intended as a description of various embodiments of the disclosed subject matter and is not intended to represent the only embodiments. Each embodiment described in this disclosure is provided merely as an example or illustration and should not be construed as preferred or advantageous over other embodiments. The illustrative examples provided herein are not intended to be exhaustive or to limit the claimed subject matter to the precise forms disclosed.

For the purposes of the present disclosure, the phrase "at least one of A, B, and C", for example, means (A), (B), (C), (A and B), (A and C), (B and C), or (A, B, and C), including all further possible permutations when more than three elements are listed. In other words, the term "at least one of A and B" generally means "A and/or B", namely "A" alone, "B" alone or "A and B".

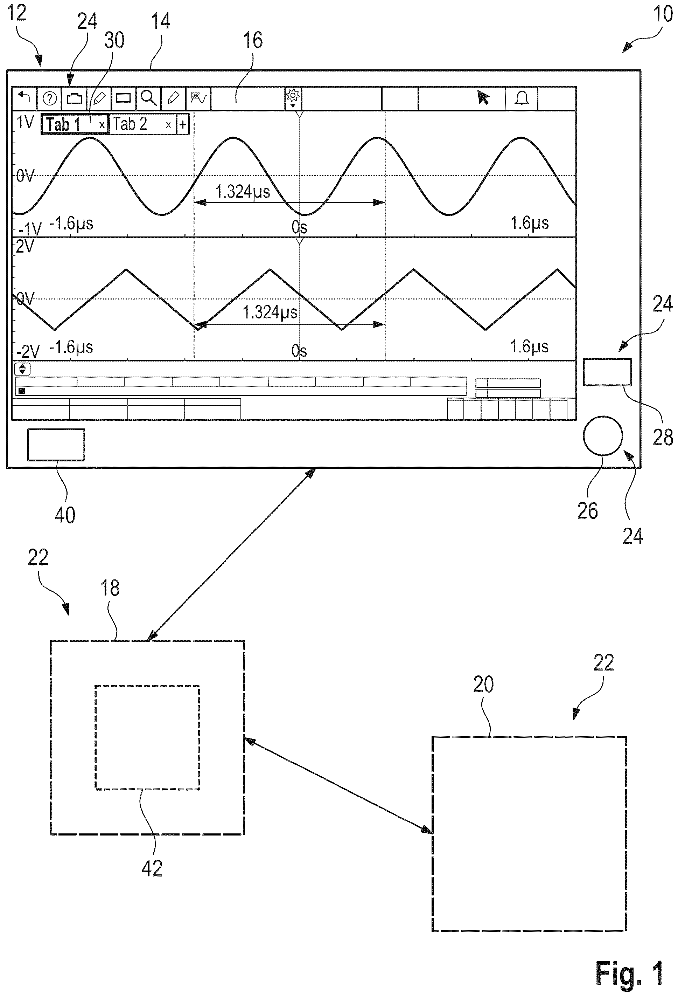

Figure 1 schematically shows a test and/or measurement system 10 that comprises a frontend device 12 in form of a test and/or measurement device 14 that comprises a display 16. Hence, the test and/or measurement system 10 has a display, e.g. the one of the test and/or measurement device 14.

The test and/or measurement system 10 also comprises a processing circuit 18 as well as a storage medium 20. The processing circuit 18 is connected to both the display 16 and the storage medium 20 in a signal-transmitting manner.

In the shown embodiment, the processing circuit 18 as well as the storage medium 20 are established by server structures in the shown embodiment. Accordingly, the processing circuit 18 and/or the storage medium 20 may relate to backend device(s) 22, for instance server structures like cloud servers.

However, the test and/or measurement device 14 may also comprise the processing circuit 18 and the storage medium 20 as internal components such that the entire test and/or measurement system 10 is established by a single device, namely the test and/or measurement device 14.

The test and/or measurement system 10, particularly the test and/or measurement device 14, further comprises an interaction item 24 besides the display 16, which may relate to a rotational and push button 26 or a button 28. The display 16 may be a touch-sensitive display such that the interaction item 24 may also be established by an active area 30 displayed on the display 16.

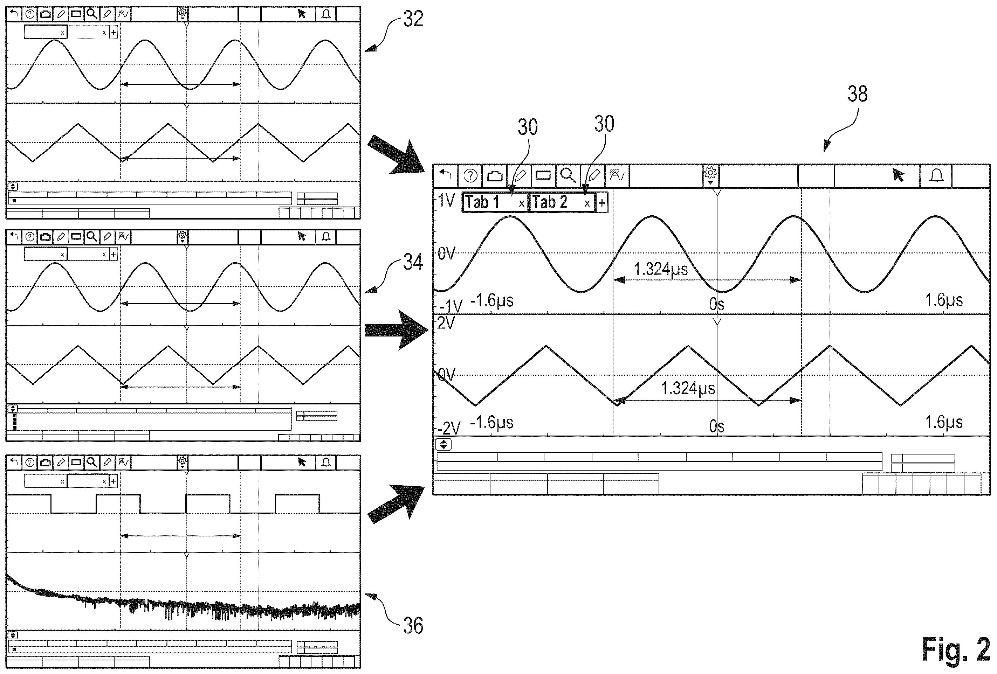

When referring to Figure 2, it is shown that different presentations can be displayed on the display 16 of the test and/or measurement system 10, namely a first presentation 32, a second presentation 34 and a third presentation 36. The different presentations 32, 34, 36 can be obtained based on different parameters when processing a signal, e.g. a measured signal or a simulated signal.

Specifically, Figure 2 illustrates that the first presentation 32 illustrates two graphs in an enlarged manner, whereas the second presentation 34 illustrates the two graphs in a compact manner, but additionally a table in the lower portion of the display 16. In addition, the third presentation 36 illustrates different graphs compared to the ones of the first presentation 32 and the second presentation 34.

Generally, the different presentations 32, 34, 36 are determined by means of the processing circuit 18 based on different parameters when processing the signal. The processing circuit 18 may determine the first presentation 32, the second presentation 34 and the third presentation 36 automatically in a temporally overlapping manner, namely at (substantially) the same time.

As shown in Figure 2, the display 16 however is only enabled to display one of the different presentations 32, 34, 36 at the same time, e.g. either the first presentation 32, the second presentation 34 or the third presentation 36 at the same time.

The test and/or measurement system 10 generally comprises an interactive screenshot functionality which, when activated, causes the processing circuit 18 to store first data associated with the first presentation 32, second data associated with the second presentation 34, and third data associated with the second presentation 36.

The processing circuit 18, particularly in case of activating the interactive screenshot functionality, causes the display 16 to serially display the different presentations, namely the first presentation 32, the second presentation 34, and the third presentation 36, on the display 16 and to obtain successive screenshots of the respective presentations when the respective presentation is currently displayed on the display 16. When obtaining the successive screenshots the respective data associated with the corresponding presentation 32, 34, 36 is gathered, which is stored in the storage medium 20.

However, the processing circuit 18 may also cause the storage medium 20 to store the respective data associated with the corresponding presentation 32, 34, 36 without actually displaying the respective presentations 32, 34, 36 on the display 16.

Once the different screenshots are obtained, namely the data of the respective presentations 32, 34, 36 gathered, the processing circuit 18 may generate an interactive screenshot 38 as shown in Figure 2 based on the different presentations 32, 34, 36.

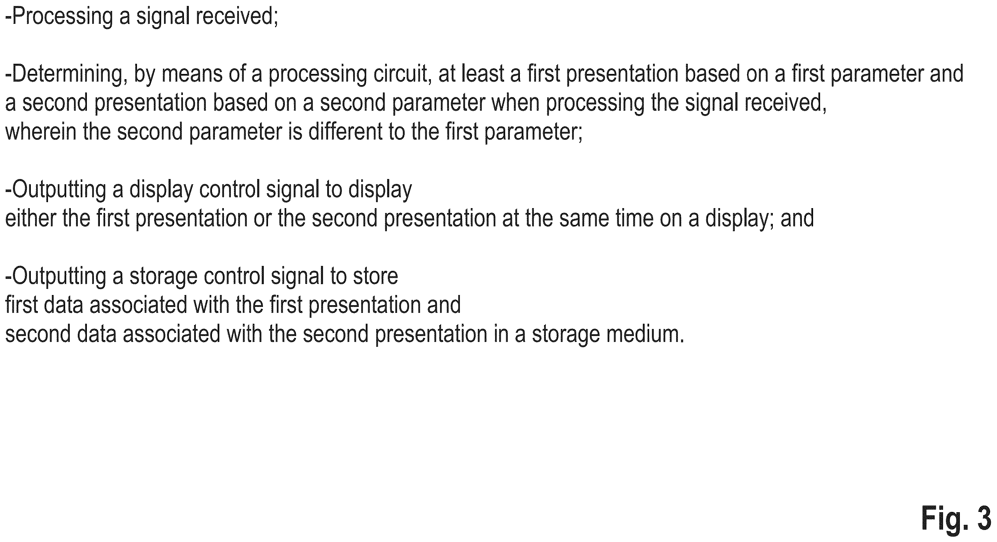

For instance, the interactive screenshot 38 is based on the first presentation 32 that is initially displayed on the display 16 when the interactive screenshot functionality is used. The first presentation 32 is generated based on the first data stored in the storage medium 20. Afterwards, the further screenshots gathered, namely the data of the further presentations like the second presentation 34 and the third presentation 36, may be merged to the interactive screenshot 38. For this purpose, active areas 30 are provided in the interactive screenshot 38, namely the basic screenshot used, e.g. the first presentation 32, as shown in Figure 3.

The active areas 30 relate to tabulators which can be selected and activated or confirmed by using the respective interaction item(s) 24 which, when used, cause(s) the processing circuit 18 to display the second presentation 34 or the third presentation 36 within the interactive screenshot 38, wherein the second presentation 34 is obtained based on the second data stored and/or the third presentation 36 is obtained based on the third data stored.

In other words, the interaction item 24, when used, switches from the first presentation 32 to the second presentation 34 or the third presentation 36 within the interactive screenshot 38.

Actually, the respective presentations 32, 34, 36 are associated with corresponding windows that are displaced on the display 16 as shown in Figure 2. The processing circuit 18 may toggle, upon an input signal, between the different windows for displaying either the first window, the second window or the third window which are associated with the first presentation 32, the second presentation 34 or the third presentation 36.

The input signal may be inputted via an input interface, for instance the interaction item 24. However, the input interface may also be established by a data interface 40 via which a control signal is obtained from a separate entity, e.g. a computer.

Generally, the first data associated with the first presentation 32, the second data associated with the second presentation 34, and/or the third data associated with the third presentation 36 comprise a temporal sequence of at least two time frames. Thus, a short video sequence may be stored which is used in the interactive screenshot 38 rather than a single moment as it is done by regular screenshots.

Besides the specific embodiments discussed, the first data associated with the first presentation 32, the second data associated with the second presentation 34 and/or the third data associated with the third presentation 36 comprise additional data not currently displayed when the respective screenshot of the corresponding presentation is obtained. For instance, the additional data relates to entries of a table, wherein the table is shown on the display 16 when the screenshot is taken, but further entries of the table are not shown. Moreover, the additional data may also relate to metadata that is not directly displayed on the display 16 when the screenshot is taken.

In general, the test and/or measurement system 10 is capable of performing a test and/or a measurement on the signal. For this purpose, the test and/or measurement system 10 may comprise the test and/or measurement device 12 as indicated above, which may relate to an oscilloscope, a spectrum analyzer, a network analyzer, a signal analyzer, an audio analyzer, a test device, a protocol tester, a mobile network tester, a measurement device, or a satellite monitoring device.

All of these different kinds of test and/or a measurement devices 12 provide several different functionalities which results in many different possible presentations which cannot be displayed on the display 16 at the same time. Consequently, the interactive screenshot functionality provided enables to obtain all information available due to the interaction with the default screenshot, e.g. the first presentation 32, which has the active areas 30 via which the other screenshots, namely the second presentation 34 and/or the third presentation 36, are linked.

Consequently, the test and/or measurement system 10, particularly its processing circuit 18, is enabled to perform a computer-implemented method of gathering data of a signal.

In a first step, a signal received is processed.

In a second step, at least a first presentation based on a first parameter and a second presentation based on a second parameter are determined by means of the processing circuit 18 when processing the signal received, wherein the second parameter is different to the first parameter.

In a third step, a display control signal is outputted by the processing circuit 18 to display either the first presentation 32, the second presentation 34 or the third presentation 36 at the same time on the display 16.

In a fourth step, a storage control signal is outputted by the processing circuit 18 to store first data associated with the first presentation 32, second data associated with the second presentation 34 and third data associated with the third presentation 36 in the storage medium 20.

In a fifth step, the processing circuit 18 generates the interactive screenshot 38 shown in Figure 2 based on the data stored in the storage medium 20, namely the first data associated with the first presentation 32, the second data associated with the second presentation 34 and the third data associated with the third presentation 36. When generating the interactive screenshot 38 by means of the processing circuit 18, the processing circuit 18 also generates the active areas 30 which provide the linkages between the different presentations 32, 34, 36.

Reference is made to the above explanations with regard to how the different screenshots are obtained, e.g. how the data of the different presentations 32, 34, 36 is gathered.

In addition, the processing circuit 18 may generally comprise a computer program product 42 that comprises instructions which, when the computer program product 42 is executed by the processing circuit 18, cause the processing circuit 18 to carry out the method described above.

Certain embodiments disclosed herein, particularly the respective module(s) and/or unit(s), utilize circuitry (e.g., one or more circuits) in order to implement standards, protocols, methodologies or technologies disclosed herein, operably couple two or more components, generate information, process information, analyze information, generate signals, encode/decode signals, convert signals, transmit and/or receive signals, control other devices, etc. Circuitry of any type can be used.

In an embodiment, circuitry includes, among other things, one or more computing devices such as a processor (e.g., a microprocessor), a central processing unit (CPU), a digital signal processor (DSP), an application-specific integrated circuit (ASIC), a field-programmable gate array (FPGA), a system on a chip (SoC), or the like, or any combinations thereof, and can include discrete digital or analog circuit elements or electronics, or combinations thereof. In an embodiment, circuitry includes hardware circuit implementations (e.g., implementations in analog circuitry, implementations in digital circuitry, and the like, and combinations thereof).

In an embodiment, circuitry includes combinations of circuits and computer program products having software or firmware instructions stored on one or more computer readable memories that work together to cause a device to perform one or more protocols, methodologies or technologies described herein. In an embodiment, circuitry includes circuits, such as, for example, microprocessors or portions of microprocessor, that require software, firmware, and the like for operation. In an embodiment, circuitry includes one or more processors or portions thereof and accompanying software, firmware, hardware, and the like.

The present application may reference quantities and numbers. Unless specifically stated, such quantities and numbers are not to be considered restrictive, but exemplary of the possible quantities or numbers associated with the present application. Also in this regard, the present application may use the term "plurality" to reference a quantity or number. In this regard, the term "plurality" is meant to be any number that is more than one, for example, two, three, four, five, etc. The terms "about", "approximately", "near" etc., mean plus or minus 5% of the stated value.

## Claims

1. A test and/or measurement system (10), wherein the test and/or measurement system (10) comprises a processing circuit (18) configured to process a signal, wherein the processing circuit (18) is configured to determine at least a first presentation based on a first parameter and a second presentation based on a second parameter when processing the signal, wherein the second parameter is different to the first parameter, wherein the test and/or measurement system (10) comprises a display (16) connected with the processing circuit (18), wherein the display (16) is configured to display either the first presentation or the second presentation at the same time, and wherein the test and/or measurement system (10) comprises a storage medium (20) configured to store first data associated with the first presentation and second data associated with the second presentation.

2. The test and/or measurement system (10) according to claim 1, wherein the test and/or measurement system (10) comprises an interactive screenshot functionality which, when activated, causes the processing circuit (18) to store the first data associated with the first presentation and the second data associated with the second presentation.

3. The test and/or measurement system (10) according to claim 1 or 2, wherein the processing circuit (18) is configured to generate an interactive screenshot comprising the first presentation that is displayed on the display (16), and wherein the test and/or measurement system (10) comprises an interaction item which, when used, causes the processing circuit (18) to display the second presentation within the interactive screenshot, wherein the second presentation is obtained based on the second data stored.

4. The test and/or measurement system (10) according to claim 3, wherein the interaction item (24), when used, switches from the first presentation to the second presentation within the interactive screenshot, wherein the second presentation is obtained based on the second data stored.

5. The test and/or measurement system (10) according to claim 3 or 4, wherein the interaction item (24) is an active area displayed on the display (16) or wherein the interaction item (24) is a button that is separately formed with respect to the display (16).

6. The test and/or measurement system (10) according to any one of the preceding claims, wherein the processing circuit (18) is configured to serially display the first presentation and the second presentation on the display (16) and to obtain successive screenshots of the first presentation and the second presentation while the first presentation and the second presentation are displayed on the display (16).

7. The test and/or measurement system (10) according to any one of the preceding claims, wherein the processing circuit (18) is configured to store the first data associated with the first presentation and the second data associated with the second presentation without displaying the respective presentations on the display (16).

8. The test and/or measurement system (10) according to any one of the preceding claims, wherein the first data associated with the first presentation and/or the second data associated with the second presentation comprise additional data not currently displayed when a screenshot of the corresponding presentation is obtained, in particular wherein the additional data is metadata.

9. The test and/or measurement system (10) according to any one of the preceding claims, wherein the first data associated with the first presentation and/or the second data associated with the second presentation comprise a temporal sequence of at least two time frames.

10. The test and/or measurement system (10) according to any one of the preceding claims, wherein the first presentation is associated with a first window and the second presentation is associated with a second window, and wherein the processing circuit (18) is configured to toggle, upon an input signal, between the first window and the second window for displaying either the first window or the second window, in particular wherein the test and/or measurement system (10) comprises an input interface via which the input signal is provided.

11. The test and/or measurement system (10) according to any one of the preceding claims, wherein the processing circuit (18) is configured to determine the first presentation and the second presentation automatically in a temporally overlapping manner.

12. The test and/or measurement system (10) according to any one of the preceding claims, wherein the signal processed by the processing circuit (18) is a measured signal or a simulated signal and/or wherein the test and/or measurement system (10) is capable of performing a test and/or a measurement on the signal.

13. The test and/or measurement system (10) according to any one of the preceding claims, wherein the test and/or measurement system (10) comprises an oscilloscope, a spectrum analyzer, a network analyzer, a signal analyzer, an audio analyzer, a test device, a protocol tester, a mobile network tester, a measurement device, or a satellite monitoring device.

14. A computer-implemented method of gathering data of a signal, wherein the method comprises the steps of:
- Processing a signal received;
- Determining, by means of a processing circuit (18), at least a first presentation based on a first parameter and a second presentation based on a second parameter when processing the signal received, wherein the second parameter is different to the first parameter;
- Outputting a display control signal to display either the first presentation or the second presentation at the same time on a display (16); and
- Outputting a storage control signal to store first data associated with the first presentation and second data associated with the second presentation in a storage medium (20).

15. A computer program product comprising instructions which, when the computer program product is executed by a processing circuit (18), cause the processing circuit (18) to carry out the method of claim 14.
